# EUROPÄISCHE PATENTSCHRIFT

(11) **EP 3 602 710 B1**
(45) Veröffentlichungstag und Bekanntmachung des Hinweises auf die Patenterteilung: **16.03.2022**
(21) Anmeldenummer: 18712583.6
(22) Anmeldetag: 20.03.2018
(51) Int. Cl.: H02H 1/06, G01R 19/00, G06F 1/26, H02H 3/20, H02H 11/00

(54) **TRENNEN EINES HAUSHALTSGERÄTS VON EINEM VERSORGUNGSNETZ**
SEPARATION OF A DOMESTIC APPLIANCE FROM A SUPPLY NETWORK
DÉCONNEXION D'UN DISPOSITIF MÉNAGER D'UN RÉSEAU D'ALIMENTATION

(30) Priorität: 29.03.2017 DE 102017205359
(43) Veröffentlichungstag der Anmeldung: 05.02.2020
(73) Patentinhaber: BSH Hausgeräte GmbH, 81739 München (DE)
(72) Erfinder: BARBU, Mircea, 93073 Neutraubling (DE); LUGAUER, Manuel, 93173 Wenzenbach (DE); MUNT, Maxim, 93047 Regensburg (DE)
(86) Internationale Anmeldenummer: PCT/EP2018/057000
(87) Internationale Veröffentlichungsnummer: WO 2018/177806

(56) Entgegenhaltungen:
- DE-A1- 10 216 784
- DE-A1-102014 211 854
- US-A1- 2014 198 337
- US-A1- 2014 218 827
- US-A1- 2015 054 489

## Beschreibung

Die Erfindung betrifft ein Haushaltsgerät, aufweisend ein Netzteil, das aus einer von einem Versorgungsnetz bereitgestellten Versorgungswechselspannung eine zum Betrieb des Haushaltsgeräts vorgesehene elektrische Leistung erzeugt, mindestens einen steuerbaren Schalter, mittels dessen das Netzteil wahlweise mit dem Versorgungsnetz verbindbar und vom Versorgungsnetz trennbar ist, und eine Spannungsmessvorrichtung zum Ermitteln eines Spannungswerts aus der Versorgungswechselspannung, wobei das Haushaltsgerät dazu eingerichtet ist, das Netzteil durch Betätigen des mindestens einen Schalters automatisch von dem Versorgungsnetz zu trennen, wenn durch die Spannungsmessvorrichtung festgestellt worden ist, dass der aus der Versorgungswechselspannung ermittelte Spannungswert einen vorgegebenen Schwellwert erreicht oder überschritten hat. Die Erfindung betrifft auch ein Verfahren zum Betreiben eines Haushaltsgerätes, bei dem ein mittels der Versorgungswechselspannung ermittelter Spannungswert durch eine Spannungsmessvorrichtung überwacht wird, der Spannungswert mittels der Spannungsmessvorrichtung mit einem vorgegebenen Schwellwert verglichen wird und das Netzteil automatisch von dem Versorgungsnetz durch Betätigen des mindestens einen Schalters getrennt wird, wenn der Spannungswert den Schwellwert erreicht oder überschritten hat. Die Erfindung ist insbesondere vorteilhaft anwendbar auf elektrisch betriebene Haushalts-Großgeräte. Die Erfindung ist beispielsweise nutzbar für Wäschebehandlungsgeräte wie Waschmaschinen, Wäschetrockner oder Kombinationen davon.

Bei einem Einsatz von Haushaltsgeräten in unterschiedlichen Regionen der Welt sind deren Umgebungsbedingungen unterschiedlich. Eine Umgebungstemperatur, eine Feuchte und/oder eine Netzspannung gehören zu wichtigen Parametern, die gemessen werden können, um eine Langlebigkeit des Haushaltsgeräts zu erhöhen. Bei Überschreitung dieser Parameter sollte ein Betrieb des Haushaltsgeräts nicht mehr fortgeführt werden. Insbesondere sollte eine Überschreitung der Netzspannung vermieden werden, um einen Ausfall von Elektronikbauteilen und/oder Aktoren zu vermeiden.

Dazu sind bisher Messungen der Netzspannung (auch als "L-Measurement" bezeichnet) nur im Betrieb möglich, d.h., dass das mindestens eine Netzrelais eingeschaltet (z.B. geschlossen) sein muss. Bei Erkennung einer Netzüberspannung werden die Netzrelais ausgeschaltet (z.B. geöffnet), jedoch ist dann folgend eine Messung der Netzspannung nicht mehr möglich. Nach einer definierten Verzögerungszeit von beispielsweise ca. 30 s werden die Netzrelais erneut eingeschaltet, so dass dann auch wieder die Netzspannung
gemessen werden kann. Dabei besteht jedoch die Gefahr, dass erneut oder weiterhin ein Überspannungszustand besteht und Elektronikbauteile und/oder Aktoren schädigen kann, bevor die Netzrelais wieder ausgeschaltet werden können.

DE 10 2010 028 569 A1 offenbart ein Haushaltsgerät, aufweisend eine elektronische Steuervorrichtung, ein Netzteil, das aus einer von einem Versorgungsnetz bereitgestellten Versorgungsspannung eine für die Steuervorrichtung vorgesehene elektrische Leistung erzeugt, und einen von der Steuervorrichtung steuerbaren Schalter, mittels dem das Netzteil mit dem Versorgungsnetz verbindbar und vom Versorgungsnetz trennbar ist. Das Haushaltsgerät weist eine mit der Steuervorrichtung verbundene Spannungsmessvorrichtung zum Ermitteln des Spannungswertes der Wechselspannung auf und die Steuervorrichtung ist eingerichtet, das Netzteil automatisch vom Versorgungsnetz durch Öffnen des Schalters zu trennen, sobald der Spannungswert der Wechselspannung einen Maximalspannungswert überschreitet.

Weitere Netzteilschaltungen für Haushaltsgeräte sind in den folgenden Dokumenten beschrieben: US 2014/0198337 A1, US 2014/0218827 A1, US 2015/0054489 A1, DE 102 16 784 A1 und DE 10 2014 211 854 A1.

Es ist die **Aufgabe** der vorliegenden Erfindung, die Nachteile des Standes der Technik zumindest teilweise zu überwinden und insbesondere eine verbesserte Möglichkeit zum Überspannungsschutz von elektrischen Bauteilen eines Haushaltsgeräts bereitzustellen.

Diese Aufgabe wird gemäß den Merkmalen des unabhängigen Anspruchs gelöst. Bevorzugte Ausführungsformen sind insbesondere den abhängigen Ansprüchen entnehmbar.

Die Aufgabe wird gelöst durch ein Haushaltsgerät, aufweisend ein erstes Netzteil, das aus einer von einem Versorgungsnetz bereitgestellten Versorgungswechselspannung eine zum Betrieb des Haushaltsgeräts vorgesehene elektrische Leistung erzeugt, mindestens einen steuerbaren Netzschalter, mittels dessen das erste Netzteil wahlweise mit dem Versorgungsnetz verbindbar und vom Versorgungsnetz trennbar ist, eine Spannungsmessvorrichtung zum Ermitteln eines Spannungswerts aus der Versorgungswechselspannung, wobei das Haushaltsgerät dazu eingerichtet ist, das erste Netzteil durch Betätigen des mindestens einen Netzschalters automatisch von dem Versorgungsnetz zu trennen, wenn durch die Spannungsmessvorrichtung festgestellt worden ist, dass der aus der Versorgungswechselspannung ermittelte Spannungswert einen vorgegebenen Schwellwert erreicht oder überschritten hat und wobei die Spannungsmessvorrichtung parallel zu dem ersten Netzteil an das Versorgungsnetz angeschlossen ist.

Dieses Haushaltsgerät weist den Vorteil auf, dass eine Messung der Netz- oder Versorgungsspannung auch bei ausgeschaltetem Netzschalter möglich ist. Dadurch kann insbesondere vermieden werden, den Netzschalter wieder einzuschalten, wenn weiterhin oder erneut eine Überspannung vorliegt. Dadurch wird ein besonders zuverlässiger Überspannungsschutz bereitgestellt. Zudem ergibt sich der Vorteil, dass das erste Netzteil praktisch unmittelbar wieder an das Versorgungsnetz anschließbar ist, wenn der Überspannungszustand vorüber ist.

Das Haushaltsgerät ist ein elektrisch betriebenes Haushaltsgerät, insbesondere ein Haushaltsgroßgerät. Das Haushaltsgerät kann beispielsweise ein Kühlgerät, ein Spülgerät oder ein Gargerät sein. Das Wäschebehandlungsgerät kann insbesondere ein Wäschetrockner oder ein Waschgerät, z.B. umfassend eine Waschmaschine oder eine Wasch/Trockner-Kombination (Waschtrockner), sein.

Unter einem Netzteil wird insbesondere eine Baugruppe des Haushaltsgeräts zur Energieversorgung anderer Baugruppen oder Komponenten des Haushaltsgeräts, die andere als von dem Versorgungsnetz bereitgestellte Spannungen und/oder Ströme benötigen, verstanden.

Die Versorgungswechselspannung kann von dem Versorgungsnetz dadurch bereitgestellt sein, dass das Haushaltsgerät an das Versorgungsnetz angeschlossen ist, z.B. über einen Versorgungsanschluss wie einen Netzstecker o.ä. Das Versorgungsnetz kann eine einphasige, zweiphasige oder dreiphasige Wechselspannung bereitstellen.

Dass das erste Netzteil eine zum Betrieb des Haushaltsgeräts vorgesehene elektrische Leistung erzeugt, kann insbesondere umfassen, dass das erste Netzteil eine zum Betrieb mindestens einer elektrischen Komponente oder Last des Haushaltsgeräts vorgesehene elektrische Leistung erzeugt oder bereitstellt. Die elektrische Komponente kann mindestens eine elektrische oder elektronische Baugruppe, mindestens einen Aktor, mindestens einen Motor, mindestens ein elektrisches Heizelement usw. umfassen.

Unter einem Netzschalter wird insbesondere ein Schalter verstanden, mittels dessen eine Leitung der Versorgungswechselspannung (entsprechend z.B. einer zugehörigen Phase) wahlweise unterbrechbar oder leitend schaltbar ist. Ein Zustand des Netzschalters, bei dem die zugehörige Leitung unterbrochen ist, wird auch als geöffneter Zustand bezeichnet. Ein Zustand des Netzschalters, bei dem die zugehörige Leitung leitend geschaltet ist, wird auch als geschlossener Zustand bezeichnet. Ist der mindestens eine Netzschalter geschlossen, ist das erste Netzteil mit dem Versorgungsnetz verbunden. Ist mindestens ein Netzschalter geöffnet, ist das erste Netzteil von dem Versorgungsnetz getrennt. Insbesondere kann für jede Leitung oder Phase ein jeweiliger Netzschalter vorhanden sein.

Dass der Netzschalter steuerbar ist, umfasst insbesondere, dass der Netzschalter elektrisch steuerbar ist.

Der Netzschalter kann ein Relais sein und dann auch als Netzrelais bezeichnet werden.

Der mittels der Spannungsmessvorrichtung ermittelte Spannungswert kann ein Wert (z.B. ein Maximal- oder Scheitelwert) der Versorgungswechselspannung oder einer aus der Versorgungswechselspannung umgewandelten Spannung sein.

Es ist eine Weiterbildung, dass die Spannungsmessvorrichtung dazu eingerichtet ist, das erste Netzteil durch Betätigen des mindestens einen Netzschalters automatisch von dem Versorgungsnetz zu trennen.

Dass die Spannungsmessvorrichtung parallel zu dem ersten Netzteil an das Versorgungsnetz angeschlossen ist, bewirkt, dass sie durch Öffnen der Netzschalter nicht auch von der Netz- oder Versorgungsspannung getrennt wird und folglich auch bei geöffneten Netzschaltern auf eine Überspannung (die mit Erreichen oder Überschreiten des Schwellwerts durch den gemessenen Spannungswert eintritt) hin überwacht.

Es ist eine Ausgestaltung, dass die Spannungsmessvorrichtung über ein zweites Netzteil an dem Versorgungsnetz angeschlossen ist. Das erste Netzteil und das zweite Netzteil können separate Baugruppen sein. Alternativ können das erste Netzteil und das zweite Netzteil in einem gemeinsamen Netzteil integriert sein.

Es ist eine Weiterbildung, dass die Spannungsmessvorrichtung dazu eingerichtet ist, einen durch das zweite Netzteil umgewandelten oder invertierten Spannungswert zu messen.

Es ist noch eine Ausgestaltung, dass das zweite Netzteil einen Brückengleichrichter, der an das Versorgungsnetz angeschlossen ist, und einen Gleichspannungswandler, der an den Brückengleichrichter angeschlossen ist, aufweist und die Spannungsmessschaltung an einem Teil des Gleichspannungswandlers, der an einem umgewandelten oder invertierten Spannungsniveau liegt, angeschlossen ist, wobei die Spannungsmessschaltung ausgangsseitig mit der Spannungsmessvorrichtung verbunden ist. Durch Nutzung des Brückengleichrichters ist eine Messung der Netzspannung (bzw. eines daraus abgeleiteten Spannungswerts) mit jeder Halbwelle möglich. Der Gleichspannungswandler ermöglicht eine Überwachung auf Überspannung durch Messung geringerer Spannungswerte, was eine einfachere und preiswertere Spannungsmessvorrichtung ermöglicht.

Es ist eine Weiterbildung, dass die Spannungsmessschaltung einen Messwert oder ein Messsignal liefert, welcher bzw. welches durch die Spannungsmessvorrichtung ausgewertet wird. Die Spannungsmessschaltung kann eine von der Spannungsmessvorrichtung separate Baugruppe oder Bauteil sein. Insbesondere in diesem Fall kann die Spannungsmessvorrichtung als Auswertevorrichtung dienen. Die Spannungsmessschaltung kann alternativ einen Teil der Spannungsmessvorrichtung darstellen, insbesondere in diese baulich integriert sein.

Es ist eine weitere Ausgestaltung, dass der Gleichspannungswandler ein Sperrwandler ist. Dies gibt den Vorteil, dass die Primärseite des Gleichspannungswandlers von seiner Sekundärseite galvanisch getrennt ist. Der Sperrwandler kann auch als Hoch-Tiefsetzsteller oder Englisch als "Flyback Converter" bezeichnet werden. Die durch die Spannungsmessschaltung abgefühlte Spannung kann dann insbesondere eine an einer Sekundärspule des Sperrwandlers anliegende Sekundärspannung sein.

Es ist noch eine weitere Ausgestaltung, dass die Spannungsmessschaltung aufweist: eine Diode, deren Kathode zwischen einer Sekundärspule und einer Anode einer Diode des Sperrwandlers angeschlossen ist, und einen Kondensator, der einerseits an eine Anode der Diode und andererseits z.B. an ein Bezugspotential angeschlossen ist, wobei ein diodenseitiger Anschluss des Kondensators mit der Spannungsmessvorrichtung verbunden ist. Das Bezugspotenzial kann Masse sein. Diese Ausgestaltung ergibt den Vorteil, dass der Kondensator über die Diode auf den Spannungswert (insbesondere der Sekundärspannung, insbesondere ihres Maximalwerts) ladbar ist und der Spannungswert mittels der Spannungsmessvorrichtung auswertbar ist, beispielsweise auf eine digitale Werteskala (z.B. auf einen Wert zwischen 0 und 255 oder zwischen 0 und 65535) skalierbar ist.

Es ist ferner eine Ausgestaltung, dass der diodenseitige Anschluss des Kondensators über einen Operationsverstärker, insbesondere über einen invertierenden Operationsverstärker, mit der Spannungsmessvorrichtung verbunden ist. So wird eine numerische Invertierung der in dem Kondensator gespeicherten Spannung erreicht, was besonders vorteilhaft ist, wenn diese Spannung durch den Sperrwandler als eine in Bezug auf die gleichgerichtete Versorgungsspannung negative und um ein Windungsverhältnis kleinere Sekundärspannung auf die Sekundärseite des Sperrwandler transformiert wird.

Es ist auch eine Ausgestaltung, dass die Spannungsmessvorrichtung einen Mikrocontroller aufweist, insbesondere ein Mikrocontroller ist. So wird auf besonders einfache und preiswerte Weise eine Auswertung der Messwerte ermöglicht. Der Mikrocontroller kann eine Komponente einer Steuereinrichtung des Haushaltsgeräts sein.

Es ist außerdem eine Ausgestaltung, dass das der mindestens eine Netzschalter ein L-Relais und ein N-Relais umfasst, insbesondere falls das Versorgungsnetz zweiphasig mit einer L-Phase und einer N-Phase ausgebildet ist. Zum Trennen des ersten Netzteils von dem Versorgungsnetz können insbesondere beide (allgemein: alle) Netzschalter geöffnet werden oder sein. Eine Messung der Versorgungsspannung durch die Spannungsmessvorrichtung ist weiterhin möglich, auch wenn das L-Relais und/oder das N-Relais geöffnet sind.

Die Aufgabe wird auch gelöst durch ein Verfahren zum Betreiben eines Haushaltsgerätes wie oben beschrieben, aufweisend folgende Verfahrensschritte: Überwachen eines aus der Versorgungswechselspannung abgeleiteten Spannungswerts mittels der Spannungsmessvorrichtung, Vergleichen des Spannungswertes mit einem vorgegebenen Schwellwert mittels der Spannungsmessvorrichtung und automatisches Trennen des ersten Netzteils von dem Versorgungsnetz durch Betätigen des mindestens einen Schalters, wenn der Spannungswert den Schwellwert erreicht oder überschritten hat, sowie Weiterführen des Überwachens des Spannungswerts mittels der Spannungsmessvorrichtung bei getrenntem ersten Netzteil.

Das Verfahren kann analog zu dem Haushaltsgerät ausgebildet werden und ergibt die gleichen Vorteile.

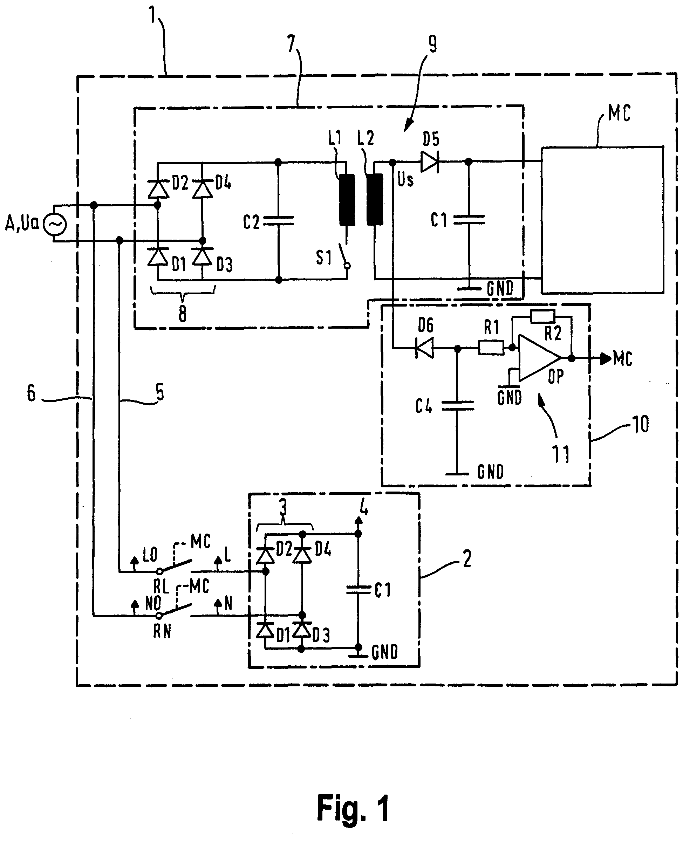

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden schematischen Beschreibung eines Ausführungsbeispiels, das im Zusammenhang mit Fig.1 näher erläutert wird.

**Fig.1** zeigt ein Haushaltsgerät 1 in Form z.B. einer Waschmaschine.

Das Haushaltsgerät 1 weist ein erstes Netzteil 2 auf, das aus einer von einem Versorgungsnetz A bereitgestellten Versorgungswechselspannung Ua eine zum Betrieb des Haushaltsgeräts 1 vorgesehene elektrische Leistung erzeugt. Das erste Netzteil 2 weist dazu einen Brückengleichrichter 3 mit vier Dioden D1 bis D4 auf. Der Brückengleichrichter 3 richtet die Versorgungswechselspannung Ua gleich. An die Ausgänge des Brückengleichrichters 3 ist ein Glättungskondensator C1 angeschlossen. An den Glättungskondensator C1 kann beispielsweise ein Stromrichter 4 (z.B. ein Gleichrichter und/oder ein Wechselrichter) angeschlossen sein, um die Versorgungswechselspannung auf eine zum Betrieb des Haushaltsgeräts 1 geeignete Form und Niveau umzuwandeln. An den Stromrichter 4 kann folglich mindestens eine elektrische Last wie eine elektrische Baugruppe oder Komponente des Haushaltsgeräts 1 usw. angeschlossen sein.

Das erste Netzteil 2 ist über zwei Stromleitungen 5, 6 an das Versorgungsnetz A angeschlossen, wobei jede der beiden Stromleitungen 5, 6 mit einem Netzschalter versehen ist, und zwar ist hier eine eine L-Phase tragende erste Stromleitung 5 mit einem L-Relais RL und eine eine N-Phase tragende zweite Stromleitung 6 mit einem N-Relais RN versehen. Bei geschlossenen (Netz-)Relais RL, RN ist das erste Netzteil 2 mit dem Versorgungsnetz A verbunden, bei geöffneten Relais RL, RN ist das erste Netzteil 2 allpolig von dem Versorgungsnetz A getrennt.

Das Haushaltsgerät 1 weist außerdem ein zweites Netzteil 7 auf, das einen Mikrocontroller MC speist. Auch das zweite Netzteil 7 ist an das Versorgungsnetz A angeschlossen, und zwar unabhängig bzw. parallel zu dem ersten Netzteil 2. Der Mikrocontroller MC ist somit unabhängig davon betreibbar, ob die Relais RL, RN geöffnet oder geschlossen sind.

Das zweite Netzteil 7 weist einen Brückengleichrichter 8 mit ebenfalls vier Dioden D1 bis D4 auf. Der Brückengleichrichter 8 ist eingangsseitig an das Versorgungsnetz A angeschlossen und ausgangsseitig über einen Glättungskondensator C2 an einen Gleichspannungswandler angeschlossen. Der Gleichspannungswandler ist hier als ein Sperrwandler 9 ausgebildet. Der Sperrwandler 9 weist eine an den Glättungskondensator C2 angeschlossene Primärspule L1 auf, die mit einem Schalter S1 in Reihe geschaltet ist. Der Schalter S1 kann ein elektronischer Schalter sein, z.B. ein Transistor. Der Schalter S1 kann zu seiner Schaltung an einen Frequenzoszillator o.ä. angeschlossen sein.

Der Sperrwandler 9 weist ferner eine von der Primärspule L1 galvanisch getrennte Sekundärspule L2 auf, an welche der Mikrocontroller MC angeschlossen ist. In einer elektrischen Leitung zwischen der Sekundärspule L2 und dem Mikrocontroller MC ist eine Diode D5 vorhanden, deren Anode mit der Sekundärspule L2 und deren Kathode mit dem Mikrocontroller MC verbunden ist. Ferner weist der Sperrwandler 9 einen Kondensator C3 auf, der einerseits mit der der Kathode der Diode D5 und andererseits an eine Bezugsspannung (Masse) GND angeschlossen ist. Der Sperrwandler 9 dient zur Übertragung elektrischer Energie zwischen einer Eingangsseite (welche an den Brückengleichrichter 8 angeschlossen ist) und einer Ausgangsseite (welche an den Mikrocontroller MC angeschlossen ist) galvanisch getrennter Gleichspannungen.

Bei einem Betrieb des Sperrwandlers 9 wird der Schalter S1 mit einer vorgegebenen Schaltfrequenz betrieben, z.B. mit einer Schaltfrequenz zwischen 16 kHz und 500 kHz. Dabei ist in einer Leitphase der Schalter S1 geschlossen und in einer Sperrphase geöffnet. Das Prinzip des Sperrwandlers 9 beruht darauf, dass eine kleine Menge Energie im Magnetfeld eines aus den Spulen L1 und L2 bestehenden Transformators gespeichert wird. Primärseitig kann zusätzlich noch eine sog. Hauptinduktivität parallel zu der Primärspule L1 vorhanden sein (o. Abb.). In der Leitphase wird die Primärspule L1 (bei Vorhandensein einer Hauptinduktivität vor allem diese) "geladen" und in der Sperrphase die gespeicherte Energie auf die Sekundärspule L2 übertragen.

Während der Leitphase sperrt die Diode D5 (Plus an Kathode), und es fließt nur ein Strom durch die Primärspule L1 (und ggf. die Hauptinduktivität). Der Strom wird durch die von dem Brückengleichrichter 8 ausgegebene gleichgerichtete und geglättete Spannung verursacht wird. Die Sekundärspule L2 ist in der Leitphase stromlos. In der Leitphase baut sich dadurch im Luftspalt zwischen Primärspule L1 und Sekundärspule L2 eine magnetische Spannung auf. In der Leitphase kommt es zu keiner Energieübertragung zwischen den Spulen L1 und L2. Eine an dem Mikrocontroller MC anliegende Ausgangsspannung des Sperrwandlers 9 wird nur durch den Kondensator C3 gehalten.

Wird der Schalter S1 geöffnet, beginnt die Sperrphase. Der zuvor durch die Primärseite und damit auch durch die Primärspule L1 fließende Strom wird durch den offenen Schalter S1 schlagartig zu null. Da aber der Strom durch die Primärspule L1 (und ggf. die Hauptinduktivität) nicht springen kann, fließt er über den Transformator L1, L2 und über die Diode D5. Dort lädt er den Kondensator C3 auf die Ausgangsspannung des Sperrwandlers 9 auf. Dieser Strom nimmt linear ab und wird im lückenden Betrieb schließlich null, wenn alle Energie aus der Sekundärspule L2 abgeflossen ist, die Spule also "entladen" ist.

Danach schließt der Schalter S1 wieder und die Leitphase beginnt erneut. Der eigentliche Energietransport von der Primärseite auf die Sekundärseite findet während der Sperrphase statt. Das Arbeitsprinzip des Sperrwandlers 9 ist grundsätzlich bekannt und wird daher nicht noch detaillierter ausgeführt. Grundsätzlich kann so durch das zweite Netzteil 7 eine ununterbrochene, auf das - im Vergleich zu der Scheitelspannung der Versorgungswechselspannung - sehr niedrige Spannungsniveau zum Betrieb des Mikrocontrollers 5 (z.B. mit einer Versorgungsgleichspannung von fünf Volt) herabgesetzt werden. Überspannungen der Versorgungswechselspannung werden durch den Sperrwandler abgeschnitten bzw. machen sich nicht schädlich bemerkbar.

An eine die Sekundärspule L2 aufweisende Sekundärseite des Sperrwandlers 9 (die an einem invertierten Spannungsniveau liegt) ist eine (Spannungs-) Messschaltung 10 angeschlossen. Die Messschaltung 10 ist ausgangsseitig mit dem Mikrocontroller MC verbunden, so dass der Mikrocontroller MC Ausgangswerte der Messschaltung 10 empfangen und verarbeiten kann, insbesondere zur Überwachung auf einen Überspannungszustand der Versorgungswechselspannung Ua.

Die Messschaltung 10 weist eine Diode D6 auf, deren Kathode zwischen der Sekundärspule L2 und der Anode der Diode D5 des Sperrwandlers 9 angeschlossen ist. Die Anode der Diode D6 ist mit einem Kondensator C4 verbunden, der andererseits an das Bezugspotential GND angeschlossen ist. Die Anode der Diode D6 bzw. der diodenseitige Anschluss des Kondensators C4 ist mit dem Mikrocontroller MC verbunden, und zwar hier über einen invertierenden Operationsverstärker 11. Der invertierende Operationsverstärker 11 weist auf grundsätzlich bekannte Weise einen Operationsverstärker OP, einen ersten ohmschen Widerstand R1 und einen zweiten ohmschen Widerstand R2 auf. Ein Ausgang des invertierenden Operationsverstärkers 11 ist mit dem Mikrocontroller MC verbunden.

Dabei wird die Erkenntnis genutzt, dass die in der Leitphase an der Primärspule L1 anliegende gleichgerichtete und geglättete Versorgungsspannung in der Sperrphase als negative und um das Windungsverhältnis der Spulen L1, L2 kleinere Sekundärspannung Us auf die Sekundärspule L2 bzw. die Sekundärseite transformiert wird. Über die Diode D6 wird der Kondensator C2 auf diesen Spannungswert der Sekundärspannung Us geladen. Durch den invertierenden Verstärker 11 wird dieser Spannungswert invertiert und ggf. skaliert und ist nun mit mittels des Mikrocontrollers MC messbar bzw. auswertbar. Der Mikrocontroller MC dient folglich als Spannungsmessvorrichtung. Der Überspannungszustand der Versorgungsspannung wird also anhand der an der Sekundärspule L2 erzeugten Sekundärspannung Us überwacht, welche aus der Versorgungsspannung Ua abgeleitet oder umgewandelt worden ist.

Erreicht oder überschreitet die Sekundärspannung Us bzw. ein daraus abgeleiteter Wert einen vorgegebenen Schwellwert, wird mittels des Mikrocontrollers MC der Überspannungszustand erkannt. Der Mikrocontrollers MC, der die elektrisch steuerbaren Netzrelais steuert, öffnet dann automatisch beide Netzrelais RL und RN und trennt dadurch das erste Netzteil 2 von dem Versorgungsnetz A.

Der Überwachungsbetrieb auf Überspannung durch das zweite Netzteil 7, die Messvorrichtung 10 und den Mikrocontroller MC ist durch das Öffnen der beiden Netzrelais RL und RN nicht betroffen, sondern wird weitergeführt. Somit können die beiden Netzrelais RL und RN vorteilhafterweise gezielt wieder geschlossen werden, wenn der Überspannungszustand vorüber ist (und nicht erst nach einer vorgegebenen Zeitdauer, bei der zudem der Überspannungszustand ggf. noch oder erneut vorliegen kann).

Das Haushaltsgerät 1 ergibt unter anderem den Vorteil, dass eine Messung der Versorgungsspannung auch dann möglich ist, wenn das L-Relais RL und das N-Relais RN geöffnet sind. Die Messung der Versorgungsspannung ist zudem mit jeder Halbwelle der Versorgungsspannung möglich.

Selbstverständlich ist die vorliegende Erfindung nicht auf das gezeigte Ausführungsbeispiel beschränkt.

So kann die Erfindung allgemein auch für einphasige oder dreiphasige usw. Stromanschlüsse bzw. Versorgungsspannungen verwendet werden.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw. Auch kann eine Zahlenangabe genau die angegebene Zahl als auch einen üblichen Toleranzbereich umfassen, solange dies nicht explizit ausgeschlossen ist.

### Bezugszeichenliste

- 1: Haushaltsgerät
- 2: Erstes Netzteil
- 3: Brückengleichrichter
- 4: Stromrichter
- 5: Erste Stromleitung
- 6: Zweite Stromleitung
- 7: Zweites Netzteil
- 8: Brückengleichrichter
- 9: Sperrwandler
- 10: Messschaltung
- 11: Invertierender Operationsverstärker
- A: Versorgungsnetz
- C1: Glättungskondensator
- C2: Glättungskondensator
- C3: Kondensator
- C4: Kondensator
- D1-D4: Dioden eines Brückengleichrichters
- D5: Diode
- D6: Diode
- GND: Bezugsspannung
- L1: Primärspule
- L2: Sekundärspule
- MC: Mikrocontroller
- OP: Operationsverstärker
- R1: Erster Widerstand
- R2: Zweiter Widerstand
- RL: L-Relais
- RN: N-Relais
- S1: Schalter
- Ua: Versorgungswechselspannung
- Us: Sekundärspannung

## Patentansprüche

1. Haushaltsgerät (1), aufweisend
ein erstes Netzteil (2), das aus einer von einem Versorgungsnetz (A) bereitgestellten Versorgungswechselspannung (Ua) eine zum Betrieb des Haushaltsgeräts (1) vorgesehene elektrische Leistung erzeugt,
mindestens einen steuerbaren Netzschalter (RL, RN), mittels dessen das erste Netzteil (2) wahlweise mit dem Versorgungsnetz (A) verbindbar und vom Versorgungsnetz (A) trennbar ist, und
eine Spannungsmessvorrichtung (MC) zum Ermitteln eines Spannungswerts (Us) aus der Versorgungswechselspannung (Ua),
wobei das Haushaltsgerät (1) dazu eingerichtet ist, das erste Netzteil (2) durch Betätigen des mindestens einen Netzschalters (RL, RN) automatisch von dem Versorgungsnetz (A) zu trennen, wenn durch die Spannungsmessvorrichtung (MC) festgestellt worden ist, dass der aus der Versorgungswechselspannung ermittelte Spannungswert (Us) einen vorgegebenen Schwellwert erreicht oder überschritten hat und wobei
die Spannungsmessvorrichtung (MC) parallel zu dem ersten Netzteil (2) an das Versorgungsnetz (A) angeschlossen ist
, wobei
die Spannungsmessvorrichtung (MC) über ein zweites Netzteil (7) an dem Versorgungsnetz (A) angeschlossen ist und
das zweite Netzteil (7) einen Brückengleichrichter (8), der an das Versorgungsnetz (A) angeschlossen ist, und einen Gleichspannungswandler (9), der eingangsseitig an den Brückengleichrichter (8)
und ausgangsseitig an die Spannungsmessvorrichtung angeschlossen ist, aufweist das Haushaltsgerät
**dadurch gekennzeichnet, dass**
an einem Teil des Gleichspannungswandlers (9), der an einem gegenüber der Brückengleichrichterausgangsspannung invertierten
Spannungsniveau liegt, eine Spannungsmessschaltung (10) angeschlossen ist, die ausgangsseitig mit der Spannungsmessvorrichtung (MC) verbunden ist.

2. Haushaltsgerät (1) nach Anspruch 1, wobei der Gleichspannungswandler ein Sperrwandler (9) ist.

3. Haushaltsgerät (1) nach Anspruch 2, wobei die Spannungsmessschaltung (10) aufweist:
eine Diode (D6), deren Kathode zwischen einer Sekundärspule (L2) und einer Anode einer Diode (D5) des Sperrwandlers (9) angeschlossen ist, und
einen Kondensator (C4), der einerseits an eine Anode der Diode (D6) und andererseits an ein Bezugspotential (GND) angeschlossen ist,
wobei ein diodenseitiger Anschluss des Kondensators (C4) mit der Spannungsmessvorrichtung (MC) verbunden ist.

4. Haushaltsgerät (1) nach Anspruch 3, wobei der diodenseitige Anschluss des Kondensators (C4) über einen Operationsverstärker (OP), insbesondere über einen invertierenden Operationsverstärker (OP, R1, R2), mit der Spannungsmessvorrichtung (MC) verbunden ist.

5. Haushaltsgerät (1) nach einem der vorhergehenden Ansprüche, wobei die Spannungsmessvorrichtung (MC) einen Mikrocontroller aufweist.

6. Haushaltsgerät (1) nach einem der vorhergehenden Ansprüche, wobei der mindestens eine Netzschalter (RL, RN) ein L-Relais (RL) und ein N-Relais (RN) umfasst.

7. Haushaltsgerät (1) nach einem der vorhergehenden Ansprüche, wobei das Haushaltsgerät (1) ein Wäschebehandlungsgerät ist, insbesondere Waschgerät.

## Claims

1. Household appliance (1), having
a first power supply unit (2), which generates electrical power intended for the operation of the household appliance (1) from a supply AC voltage (Ua) provided by a supply network (A),
at least one controllable power switch (RL, RN), by means of which the first power supply unit (2) can be optionally connected to the supply network (A) and disconnected from the supply network (A), and
a voltage measurement apparatus (MC) for determining a voltage value (Us) from the supply AC voltage (Ua),
wherein the household appliance (1) is configured to automatically disconnect the first power supply unit (2) from the supply network (A) by actuating the at least one power switch (RL, RN) if it has been ascertained by the voltage measurement apparatus (MC) that the voltage value (Us) determined from the supply AC voltage has reached or exceeded a predefined threshold value and wherein
the voltage measurement apparatus (MC) is connected to the supply network (A) in parallel with the first power supply unit (2), wherein
the voltage measurement apparatus (MC) is connected to the supply network (A) via a second power supply unit (7) and
the second power supply unit (7) has a bridge rectifier (8), which is connected to the supply network (A), and a DC voltage converter (9), which is connected on the input side to the bridge rectifier (8) and on the output side to the voltage measurement apparatus, the household appliance being **characterised in that** a voltage measurement circuit (10), which is connected on the output side to the voltage measurement apparatus (MC), is connected to a part of the DC voltage converter (9) which lies at a voltage level that is inverted compared to the bridge rectifier output voltage.

2. Household appliance (1) according to claim 1, wherein the DC voltage converter is a flyback converter (9).

3. Household appliance (1) according to claim 2, wherein the voltage measurement circuit (10) has:
a diode (D6), the cathode of which is connected between a secondary coil (L2) and an anode of a diode (D5) of the flyback converter (9), and
a capacitor (C4), which is connected on the one side to an anode of the diode (D6) and on the other side to a reference potential (GND),
wherein a diode-side connection of the capacitor (C4) is connected to the voltage measurement apparatus (MC).

4. Household appliance (1) according to claim 3, wherein the diode-side connection of the capacitor (C4) is connected to the voltage measurement apparatus (MC) via an operational amplifier (OP), in particular via an inverting operational amplifier (OP, R1, R2).

5. Household appliance (1) according to one of the preceding claims, wherein the voltage measurement apparatus (MC) has a microcontroller.

6. Household appliance (1) according to one of the preceding claims, wherein the at least one power supply unit (RL, RN) comprises an L relay (RL) and an N relay (RN).

7. Household appliance (1) according to one of the preceding claims, wherein the household appliance (1) is a laundry treatment appliance, in particular a washing appliance.

## Revendications

1. Appareil électroménager (1) comprenant
un premier adaptateur (2), lequel produit d'un courant alternatif d'alimentation (Ua) fourni par un réseau d'alimentation (A), une puissance électrique prévue pour faire fonctionner l'appareil électroménager (1),
au moins un commutateur de réseau (RL, RN) à commander, au moyen duquel le premier adaptateur (2) peut être à volonté relié au réseau d'alimentation (A) et déconnecté du réseau d'alimentation (A), et
un dispositif de mesure de la tension (MC) pour la détection d'une valeur de tension (Us) du courant alternatif d'alimentation (Ua),
dans lequel l'appareil électroménager (1) est prévu pour déconnecter automatiquement du réseau d'alimentation (A) le premier adaptateur (2), par l'actionnement du au moins un commutateur de réseau (RL, RN), quand le dispositif de mesure de la tension (MC) établit que la valeur de tension (Us) détectée du courant alternatif d'alimentation, a atteint ou dépassé une valeur de seuil prédéfinie, et
dans lequel le dispositif de mesure de la tension (MC) est raccordé parallèlement au premier adaptateur (2), au réseau d'alimentation (A),
le dispositif de mesure de la tension (MC) étant raccordé par un deuxième adaptateur (7), au réseau d'alimentation (A), et
le deuxième adaptateur (7) comprenant un redresseur en pont (8), raccordé au réseau d'alimentation (A), et un convertisseur continu-continu (9), raccordé côté entrée au redresseur en pont (8) et côté sortie, au dispositif de mesure de la tension, l'appareil électroménager étant **caractérisé en ce que**
sur une partie du convertisseur continu-continu (9), se trouvant sur un niveau de tension inversé par rapport à la tension de sortie du redresseur en pont, un circuit de mesure de la tension (10) est raccordé, relié côté sortie au dispositif de mesure de la tension (MC).

2. Appareil électroménager (1) selon la revendication 1, dans lequel le convertisseur continu-continu est un convertisseur à oscillateur bloqué (9).

3. Appareil électroménager (1) selon la revendication 2, dans lequel le circuit de mesure de la tension (10) comprend :
une diode (D6) dont la cathode est raccordée entre la bobine secondaire (L2) et l'anode d'une diode (D5) du convertisseur à oscillateur bloqué (9), et
un condensateur (C4), est raccordé d'une part à l'anode de la diode (D6) et d'autre part à un potentiel de référence (GND),
dans lequel une connexion côté diode du condensateur (C4) est reliée au dispositif de mesure de la tension (MC).

4. Appareil électroménager (1) selon la revendication 3, dans lequel la connexion côté diode du condensateur (C4) est reliée par un amplificateur opérationnel (OP), en particulier par un amplificateur opérationnel inversé (OP, R1, R2), au dispositif de mesure de la tension (MC).

5. Appareil électroménager (1) selon l'une des revendications précédentes, dans lequel le dispositif de mesure de la tension (MC) comprend un microcontrôleur.

6. Appareil électroménager (1) selon l'une des revendications précédentes, dans lequel le au moins un commutateur de réseau (RL, RN) comprend un relais-L (RL) et un relais-N (RN).

7. Appareil électroménager (1) selon l'une des revendications précédentes, dans lequel l'appareil électroménager (1) est un appareil de traitement du linge, en particulier un appareil de lavage.
